# EUROPÄISCHE PATENTANMELDUNG

(11) **EP 0 757 413 A2**
(43) Veröffentlichungstag der Anmeldung: **05.02.1997**
(21) Anmeldenummer: 96110559.0
(22) Anmeldetag: 29.06.1996
(51) Int. Cl.: H01R 31/06

(54) **Adapter mit einem eine Kontaktierungsvorrichtung aufweisenden Träger**

(30) Priorität: 31.07.1995 DE 19528011
(71) Anmelder: KONTRON ELEKTRONIK GMBH, D-85386 Eching (DE)
(72) Erfinder: Horak, Dieter, 85368 Moosburg (DE); Habermayr, Erwin, 86697 Oberhausen (DE)
(74) Vertreter: Bullwein, Fritz

(57) **Zusammenfassung**

Bei einem Adapter mit einem eine Kontaktierungsvorrichtung aufweisenden Träger zur elektrischen Verbindung von elektrischen Kontakten eines auf einer Platine aufgebrachten elektronischen Bauteils mit einem Testgerät wird die Kontaktierungsvorrichtung durch ein kontakteübergreifendes elektrisches Verbindungsstück mit rasterförmigen Leitungsabschnitten gebildet.

Vorzugsweise weist der Träger mindestens einen Durchbruch für eine lösbare mechanische Verbindung mit dem elektronischen Bauteil oder mit der Platine auf.

## Beschreibung

Die Erfindung bezieht sich auf einen Adapter mit einem eine Kontaktierungsvorrichtung aufweisenden Träger nach dem Oberbegriff des Patentanspruchs 1.

Derartige Adapter sind beispielsweise bekannt, um Testgeräte, wie Logic Analyzer oder In-circuit Emulatoren an Mikroprozessoren oder anderen integrierten Schaltungen, die in flachen Gehäusen eingegossen sind (FPGA Gehäuse), anzuschließen. Die hierzu üblichen "clip over" Adapter bestehen aus einer Adapterplatine als Träger, die eine Kontaktierungsvorrichtung in Form eines oder mehrerer Sockel mit elektrisch leitenden Federkontakten aufweisen. Dieser Adapter wird beispielsweise von oben auf ein SMD-gelötetes elektronisches Bauteil gesteckt. Die an dem Adapter angebrachten Federkontakte schaffen zum einen eine elektrische Verbindung zwischen den Kontakten (z.B. Pins, Anschlußbeinen) des auf einer Platine aufgebrachten elektronischen Bauteils und einem Testgerät und zum anderen eine lösbare mechanische Verbindung zur Befestigung des Adapters an dem elektronischen Bauteil.

Die Verwendung von Federkontakten als Kontaktierungsvorrichtung des Adapters weist mit zunehmender Miniaturisierung der elektronischen Bauteile sowohl mechanische als auch elektrische Probleme auf. Zum einen reicht die Haltekraft der immer kleiner werdenden Federkontakte nicht mehr für eine ausreichende Befestigung des Adapters auf dem zu testenden Bauteil aus, zum anderen besteht durch die schwierige Positionierbarkeit aufgrund der Miniaturisierung die Gefahr von Kurzschlüssen zwischen den Kontakten des elektronischen Bauteils.

Es ist Aufgabe der Erfindung, einen Adapter eingangs genannter Art derart zu verbessern, daß auch bei zunehmender Miniaturisierung der elektronischen Bauteile Kurzschlüsse sicher verhindert werden.

Diese Aufgabe wird durch die kennzeichnenden Merkmale des Patentanspruches 1 gelöst.
Erfindungsgemäß wird die Kontaktierungsvorrichtung durch ein kontakteübergreifendes elektrisches Verbindungsstück mit rasterförmigen Leitungsabschnitten, im folgenden nur noch Verbindungsstück genannt, gebildet.

Derartige Verbindungsstücke bestehen beispielsweise aus parallel angeordnete Kontaktabschnitte aufweisendem Isoliermaterial. Beispielsweise können hierfür Kunststoffe verwendet werden, in die bzw. um die eine Vielzahl von parallel angeordneten dünnen Metalldrähten eingegossen bzw. angebracht sind. Auch können Kunststoffe verwendet werden, die in abwechselnd leitenden und isolierenden Schichten aufgebaut sind. Hochauflösende Raster in Form von parallel angeordeten leitenden Abschnitten werden erfindungsgemäß bevorzugt.

Das Verbindungsstück wird derart angeordnet, daß sich zwischen den Kontakten des elektronischen Bauteils und den entsprechenden auf dem Träger aufgebrachten Kontaktanschlüssen für die Kontaktierungsvorrichtung elektrisch leitfähige Verbindungen ergeben. Unter dem Begriff kontakteübergreifend wird verstanden, daß sich das Verbindungsstück über mehrere oder alle nebeneinanderliegende elektrische Kontakte erstreckt, wodurch auch die Positionierung der Kontaktierung des Adapters mit dem elektronischen Bauteil erleichtert wird. Gleichzeitig wirkt das Verbindungsstück zwischen den nebeneinanderliegenden Kontakten des elektronischen Bauteils bzw. zwischen den Kontaktanschlüssen der Kontaktierungsvorrichtung als Isolator.

Ein derartiges Verbindungsstück kann beispielsweise auch Vorrichtungen zur Befestigung des Adapters am elektronischen Bauteil aufweisen. Somit ist eine einfache kurzschlußsichere Kontaktierung eines Adapters mit einem elektronischen Bauteil gewährleistet.

Eine vorteilhafte Weiterbildung der Erfindung ist der Gegenstand des Patentanspruchs 2.
Erfindungsgemäß weist der Träger mindestens einen Durchbruch für eine lösbare mechanische Verbindung mit dem elektronischen Bauteil oder mit der Platine, auf der das elektronische Bauteil aufgebracht ist, auf.
Hierdurch wird eine stärkere Befestigungsvorrichtung ermöglicht, um keine Haltekräfte auf die einzelnen Kontakte des elektronischen Bauteils wirken zu lassen. Zusätzlich zu einer leicht positionierbaren kurzschlußfreien Kontaktierung wird eine Beschädigung durch die Befestigung des Adapters auf dem elektronischen Bauteil verhindert.

In der Zeichnung ist ein Ausführungsbeispiel der Erfindung dargestellt. Es zeigt:
- Fig. 1: eine erste Möglichkeit, einen Durchbruch im Träger des Adapters vorzusehen,
- Fig. 2: eine zweite Möglichkeit, Durchbrüche an dem Träger des Adapters vorzusehen,
- Fig. 3: zwei mögliche lösbare mechanische Verbindungen zwischen einem elektronischen Bauteil und einem Adapter, dessen Kontaktierungsvorrichtung ein kontakteübergreifendes elektrisches Verbindungsstück mit rasterförmigen Leitungsabschnitten in Form eines in vertikaler Richtung leitenden Kunststoffstreifens aufweist und
- Fig. 4: eine vergrößerte Darstellung des Verbindungsstückes

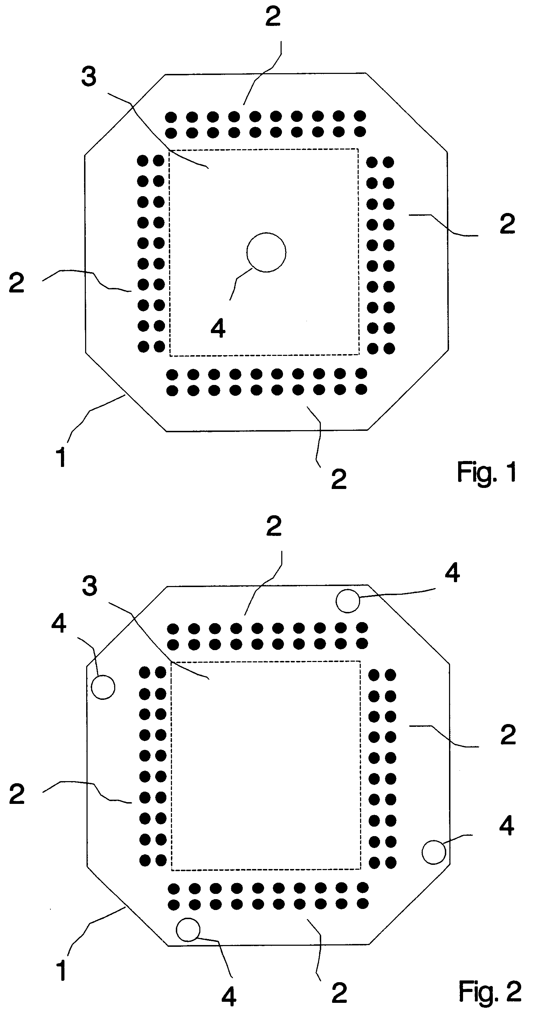

Fig. 1 zeigt einen Adapter mit einem eine Kontaktierungsvorrichtung 2 aufweisenden Träger 1, der beispielsweise für einen Mikroprozessor als elektronisches Bauteil 3 vorgesehen ist. In Fig. 1 ist der Durchbruch 4 des Trägers 1 in der Mitte des Trägers 1, der Kontaktierungsvorrichtung 2 und des elektronischen Bauteils 3, wenn der Träger 1 bereits auf das elektronische Bauteil 3 aufgesetzt wurde. Fig. 2 zeigt einen Adapter, der im Unterschied zu Fig. 1 vier Durchbrüche 4 am Rand des Trägers 1 aufweist. Da der Rand des Trägers 1 über das elektronische Bauteil 3 und dessen Kontakte entsprechend der Kontaktierungsvorrichtung 2 hinausreicht, kann nach dem Beispiel in Fig. 2 eine Befestigung des Trägers 1 über die Durchbrüche 4 an der Platine vorgenommen werden, auf der das Bauteil 3 aufgebracht ist.

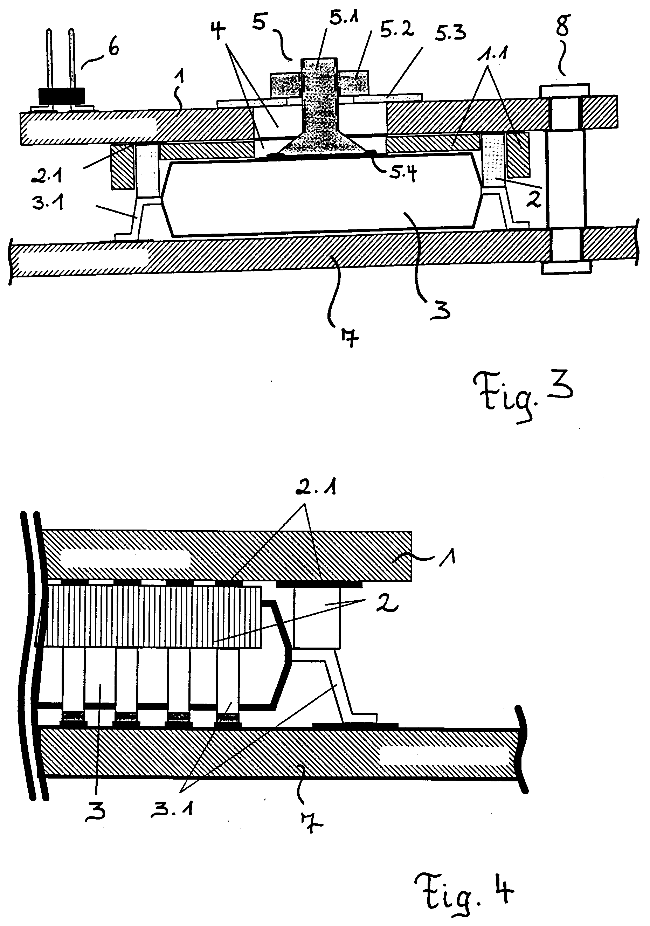

Fig. 3 zeigt einen Schnitt durch den Adapter, bestehend aus dem Träger 1 und der Kontaktierungsvorrichtung 2, durch das elektronische Bauteil 3, auf dem der Adapter aufgesetzt ist und durch die Platine 7, auf der das Bauteil 3 aufgebracht ist, in Seitenansicht.

Der Träger 1 weist einen Sockel 1.1 auf, durch den die Kontaktierungsvorrichtung 2 bzw. das kontakteübergreifende elektrische Verbindungsstück 2 mit rasterförmigen Leitungsabschnitten in Form eines in eine Richtung leitenden Kunststoffstreifen gehalten und mit dem Träger 1 verbunden wird. Die Kontaktierungsvorrichtung 2 ist elektrisch mit den Steckern 6 verbunden, die zu einem hier nicht dargestellten Testgerät weiterführen.

Die in eine Richtung (hier vertikal) leitenden Verbindungsstücke 2 sind über Kontaktflächen 2.1, deren Anordnung der Anordnung der Kontakte 3.1 des Bauteils 3 entspricht mit dem Träger 1 leitend verbunden. Vorzugsweise erstreckt sich je ein Verbindungsstück 2 horizontal (Fig. 4) jeweils über die gesamte Länge einer Kontaktreihe der Kontakte 3.1 auf einer Seite des Bauteils 3.

Die Kontaktstreifen 2 werden lediglich auf die Kontakte 3.1 des Bauteils 3 aufgesetzt. Kontaktzonen des elektrischen Verbindungsstückes 2, die jeweils zwischen einer Kontaktfläche 2.1 und einem Kontakt 3.1 liegen, bilden die elektrisch leitfähige Verbindung. In horizontaler Richtung, d. h. zwischen den einzelnen Kontakten 3.1 oder zwischen den einzelnen Kontaktflächen 2.1, wirkt der nur in vertikaler Richtung leitende Kunststoffstreifen 2 als Isolator. Diese Art der elektrischen Verbindung ist besonders günstig, um Kurzschlüsse zu verhindern.

Im Träger 1 sowie im Sockel 1.1 des Trägers 1 ist jeweils ein Durchbruch 4 vorgesehen, durch den eine lösbare mechanische Verbindung 5 in Form einer Verschraubung führt. Die lösbare mechanische Verbindung 5 setzt sich aus einer Schraube 5.1, die mittels eines lösbaren Klebstoffes 5.4 auf der Oberseite des Gehäuses des Bauteils 3 aufgebracht ist, aus einer Beilagscheibe 5.3 und aus einer Mutter 5.2 zusammen.

Zusätzlich ist in Fig. 3 eine lösbare mechanische Verbindung 8 zwischen dem Träger 1 des Adapters und der Platine 7, auf der das Bauteil 3 aufgebracht ist, vorgesehen.
Die mechanische Befestigung des Adapters bzw. des Trägers 1 wird alternativ oder zusätzlich zur mechanischen Verbindung 5 des Trägers 1 mit dem Bauteil 3 durch die mechanische Verbindung 8 des Trägers 1 mit der Platine 7 vorgenommen. Die Verbindung 8 kann beispielsweise ebenfalls mittels einer Verschraubung durch die Durchbrüche in dem Träger 1 und der Platine 7 hindurch und mittels eines Abstandsbolzens zwischen dem Träger 1 und der Platine 7 vorgenommen werden.

Anstelle einer Verschraubung kann die Verbindung 8 beispielsweise auch durch einen Kunststoffstift mit Schnappverbindung gebildet werden. Auch kann beispielsweise die Verbindung 5 statt mit einer Schraube mit einem auf dem Bauteil 3 haltenden Saugknopf vorgenommen werden.

In Fig. 4 ist insbesondere das Verbindungsstück 2 als in (hier) vertikaler Richtung leitendes Kunststoffstück 2 vergrößert dargestellt. Fig. 4 zeigt eine Seitenansicht von einem Bauteil 3 mit einem flachen rechteckigen Gehäuse und einer Reihe von Kontakten 3.1 an jeder Seite des Gehäuses. Die Kontakte 3.1 sind beispielsweise entsprechend den Kontaktanschlüssen der Kontaktierungsvorrichtung 2 auf den in Fig. 1 und Fig. 2 dargestellten Adaptern angeordnet. Über die Kontakte 3.1 ist das elektronische Bauteil 3 auf der Platine 7 aufgebracht.

Der Träger 1 des Adapters weist entsprechend der Kontakte 3.1 Kontaktanschlüsse 2.1, z. B. in Form von Kontaktflächen oder sog. PADs, auf (vgl. auch Kontaktanschlüsse der Kontaktierungsvorrichtung in den Fig. 1 und 2). Jedem einzelnen Kontakt 3.1 ist ein Kontaktanschluß 2.1 auf dem Träger 1 und diesem wiederum ein Stecker 6 (Fig. 3) auf der Oberseite des Trägers 1 zugeordnet. Die Stecker 6 sind mit einem hier nicht dargestellten Testgerät verbunden. Somit werden die einzelnen Kontakte 3.1 über die Gesamtvorrichtung des Adapters an das Testgerät angeschlossen. Die elektrische Verbindung zwischen den Kontakten 3.1 und den Kontaktanschlüssen 2. 1 wird mittels der in eine Richtung leitenden Kunststoffstreifen 2 hergestellt, die sich jeweils über die Kontaktreihen einer Seite des Bauteils 3 erstrecken und die elektrisch leitfähig mit den Kontaktanschlüssen 2.1 des Trägers 1 fest verbunden sind.

In Fig. 4 wird mit der vertikalen Schraffur des linken Kunststoffstreifens 2 die Richtung, in der die leitenden Abschnitte wirken, angezeigt. Zwischen den nebeneinanderliegenden Kontakten 3.1 oder den nebeneinanderliegenden Kontaktanschlüssen 2.1, d. h. in senkrechter Richtung zu den vertikalen Schraffurlinien, wirkt der Kunststoffstreifen 2 isolierend. Eine wichtige Anforderung an das Verbindungsstück 2 für dessen erfindungsgemäße Anwendung ist, daß die Auflösung der abwechselnd geschichteten isolierenden Bereiche und leitenden Bereiche des Kunststoffes in Richtung der voneinander zu isolierenden Kontakte 3.1 oder Kontaktanschlüsse 2.1 mindestens doppelt so hoch wie die Abstände dieser nebeneinanderliegenden Kontakte 3.1 oder Kontaktanschlüsse 2.1 ist. In Fig. 4 ist der linke Kunststoffstreifen 2 in abwechselnd isolierenden (weißen) und leitfähigen (schwarzen) Schichten dargestellt. Betrachtet man die Abstände der leitenden, in vertikaler Richtung schwarz dargestellten Bereiche voneinander, ist die Auflösung des Kunststoffstreifens 2 bezüglich der abwechselnd leitenden und isolierenden Bereiche ca. 4 mal höher als die Abstände der Kontake 3.1 oder der Kontaktanschlüsse 2.1 voneinander. Je stärker die Miniaturisierung eines Bauteils vorgenommen wird, d. h. je kleiner und enger die Kontakte 3.1 angeordnet werden, umso höher muß die Auflösung der abwechselnd isolierenden und leitfähigen Bereiche des Kunststoffes 2 sein.

Besonders vorteilhaft an dem Ausführungsbeispiel ist, daß sich der in eine Richtung leitende Kunststoff über mehrere nebeneinanderliegende Kontakte in einem Stück erstrecken kann, so daß an die Positionierung der Kontaktierungsvorrichtung keine hohen Anforderungen gestellt werden müssen. Gleichzeitig wird ein Höchstmaß an Kurzschlußsicherheit gewährleistet.

## Patentansprüche

1. Adapter mit einem eine Kontaktierungsvorrichtung aufweisenden Träger zur elektrischen Verbindung von elektrischen Kontakten eines auf einer Platine aufgebrachten elektronischen Bauteils mit einem Testgerät, dadurch gekennzeichnet, daß die Kontaktierungsvorrichtung (2, 2.1) durch ein kontakteübergreifendes elektrisches Verbindungsstück mit rasterförmigen Leitungsabschnitten gebildet wird.

2. Adapter nach Patentanspruch 1, dadurch gekennzeichnet, daß der Träger (1, 1.1) mindestens einen Durchbruch (4) für eine lösbare mechanische Verbindung (5; 5.1, 5.2, 5.3, 5.4; 8) mit dem elektronischen Bauteil (3) oder mit der Platine (7) aufweist.
